# EUROPEAN PATENT APPLICATION

(11) **EP 4 815 299 A1**
(43) Date of publication of application: **30.09.2026**
(21) Application number: 26161940.7
(22) Date of filing: 03.03.2026
(51) Int. Cl.: H03F 1/52, H03F 3/45, H10D 89/60

(54) **SYSTEMS AND METHODS FOR INPUT LEAKAGE REDUCTION AND LINEARITY IMPROVEMENT IN SIGNAL PROCESSING SYSTEMS**

(30) Priority: 24.03.2025 US 202519087811
(71) Applicant: Avago Technologies International Sales Pte. Limited, Singapore 768923 (SG)
(72) Inventor: Lu, Junjie, Irvine, CA, 92620 (US); Guo, Jing, Irvine, CA, 92618 (US); Wang, Leon Samuel, Irvine, CA, 92602 (US); Crohn, Joshua, Gilbert, AZ, 85298 (US); Lin, Da-Hsien, Gilbert, AZ, 85295 (US); Jiang, Xicheng, irvine, CA, 92612 (US)
(74) Representative: Grünecker Patent- und Rechtsanwälte PartG mbB

(57) **Abstract**

The subject technology is directed to electronic circuits. In an embodiment, the subject technology provides an apparatus that includes an input terminal configured to receive an input signal. The apparatus further includes a first circuit coupled to the input terminal, the first circuit comprising a first transistor coupled to the input terminal and a level-shifter coupled to the first transistor. A second circuit is coupled to the first circuit, the second circuit comprising a second transistor, the second transistor including a base terminal coupled to a first supply voltage. The apparatus further includes an amplifier comprising a first input and an output, the amplifier being configured to generate an output signal by amplifying the input signal. By optimizing electrostatic discharge (ESD) protection, electrical overstress (EOS) protection, and leakage control in the analog front-end (AFE), the apparatus reduces leakage current and minimizes nonlinearity. There are other embodiments as well.

## Description

### BACKGROUND

The subject technology is directed to electronic circuits.

### BACKGROUND OF THE INVENTION

In modern electronic systems, analog front-end (AFE) circuits play an important role in acquiring and processing signals from high-impedance sources. These systems are widely used in various applications, such as healthcare sensing, industrial monitoring, and/or scientific instrumentation, where accurate signal acquisition is beneficial for reliable system performance. In healthcare sensing systems, for example, bio-signal acquisition relies on electrodes to detect weak electrophysiological signals, such as electrocardiography (ECG), electroencephalography (EEG), and electromyography (EMG). Dry electrodes are often preferred due to their ease of use, long-term stability, and biocompatibility; however, they exhibit poor conductance, which is limited by their compact size and the quality of contact with the signal source. The equivalent source impedance of a dry electrode-which may be modeled as a parallel RC circuit-can reach tens of megaohms in resistance and hundreds of picofarads in capacitance. The high source impedance creates challenges in signal acquisition, requiring front-end circuits with ultra-high input impedance and minimal leakage current to maintain signal integrity.

In high-impedance signal acquisition systems, the front-end circuit must have an input impedance significantly higher than that of the source to avoid signal attenuation. For example, in healthcare sensing applications, the input impedance of the front-end circuit may be required to be above gigaohms. Additionally, the leakage current at the input must remain in the picoampere range to minimize noise contributions from leakage-induced shot noise, which degrades the system's signal-to-noise ratio. Moreover, leakage currents that vary with signal voltage can introduce non-linear distortions, particularly when coupled with a high-impedance signal source. Such non-linearity affects signal fidelity, resulting in errors in measurements and degraded system performance.

Leakage of front-end circuits may originate from various sources, such as board trace leakage, electrostatic discharge (ESD) leakage, electrical overstress (EOS) clamp leakage, leakage of a termination ground switch (GNDSW) which is used to reset the electrode voltage, and leakage of a front-end low aging drift low offset amplifier under electrical overstress over time, and/or the like. Various approaches for improving input protection in high-impedance sensing systems have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a block diagram illustrating a signal acquisition system, in accordance with various embodiments of the subject technology.
Figure 2 is a circuit diagram illustrating leakage sources in an analog front-end (AFE) circuit, in accordance with various embodiments of the subject technology.
Figure 3 is a circuit diagram illustrating an analog front-end (AFE) circuit for minimizing leakage, in accordance with various embodiments of the subject technology.
Figure 4A is a circuit diagram illustrating an electrostatic discharge (ESD) protection circuit, in accordance with various embodiments of the subject technology.
Figure 4B is a circuit diagram illustrating a level-shifter of an electrostatic discharge (ESD) protection circuit, in accordance with various embodiments of the subject technology.
Figure 5A is a circuit diagram illustrating an electrical overstress (EOS) protection circuit, in accordance with various embodiments of the subject technology.
Figure 5B is a circuit diagram illustrating back-power protection switches of an electrical overstress (EOS) protection circuit, in accordance with various embodiments of the subject technology.
Figure 6 is a circuit diagram illustrating a ground switch, in accordance with various embodiments of the subject technology.
Figure 7A is a circuit diagram illustrating a series switch system, in accordance with various embodiments of the subject technology.
Figure 7B is a circuit diagram illustrating a series switch, in accordance with various embodiments of the subject technology.
Figure 7C is a circuit diagram illustrating a series switch, in accordance with various embodiments of the subject technology.
Figure 7D is a circuit diagram illustrating a first stage pre-amplifier of an amplifier, in accordance with various embodiments of the subject technology.
Figure 7E is a circuit diagram illustrating a biasing circuit of an amplifier, in accordance with various embodiments of the subject technology.
Figure 8 is a circuit diagram illustrating an analog front-end (AFE) circuit with a guard buffer system, in accordance with various embodiments of the subject technology.

### DETAILED DESCRIPTION

The subject technology is directed to electronic circuits. In an embodiment, the subject technology provides an apparatus that includes an input terminal configured to receive an input signal. The apparatus further includes an optimized electrostatic discharge (ESD) protection circuit, which includes a first circuit coupled to the input terminal, the first circuit comprising a first transistor coupled to the input terminal and a level-shifter coupled to the first transistor, the level-shifter being configured to provide a first bias voltage to the first transistor. The apparatus further includes an optimized electrical overstress (EOS) protection circuit, which includes a second circuit is coupled to the first circuit, the second circuit comprising a second transistor, the second transistor including a base terminal coupled to a first supply voltage. The apparatus also includes a first switch coupled to the input terminal and a ground potential, the first switch is configured to establish a first conduction path between the input terminal and the ground potential in response to a first control signal. The apparatus further includes an amplifier comprising a first input and an output, the amplifier being configured to generate an output signal by amplifying the input signal. A second switch is coupled to the input terminal and the first input of the amplifier. An output terminal is coupled to the output of the amplifier, the output terminal is configured to provide the output signal. By optimizing electrostatic discharge (ESD) protection, electrical overstress (EOS) protection, and leakage control in the analog front-end (AFE), the apparatus reduces leakage current and minimizes non-linearity, improving overall system stability and performance. There are other embodiments as well.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus, which comprises an input terminal configured to receive an input signal. The apparatus further comprises a first circuit coupled to the input terminal. The first circuit comprises a first transistor coupled to the input terminal, and a level-shifter coupled to the first transistor and configured to provide a first bias voltage to the first transistor. The apparatus further comprises a second circuit coupled to the first circuit, the second circuit comprising a second transistor, the second transistor comprising a base terminal coupled to a first supply voltage. The apparatus further comprises a first switch coupled to the input terminal and a ground potential, the first switch being configured to establish a first conduction path between the input terminal and the ground potential in response to a first control signal. The apparatus further comprises an amplifier comprising a first input and an output, the amplifier being configured to generate an output signal by amplifying the input signal. The apparatus further comprises a second switch coupled to the input terminal and the first input of the amplifier. The apparatus further comprises an output terminal coupled to the output of the amplifier, the output terminal being configured to provide the output signal.

Implementations may include one or more of the following features. The first transistor is coupled to the input terminal and a first node, the level-shifter is configured to provide a first voltage at the first node, the first voltage is greater than a second voltage at the input terminal by a first offset. The level-shifter comprises a voltage generator coupled to the first node, the voltage generator is configured to determine the first offset. The first circuit is configured to conduct a transient current between the input terminal and the first node in response to a voltage transient event. The first switch comprises a third transistor comprising a bulk terminal coupled to the first supply voltage. The amplifier further comprises a second input. The apparatus further comprises a third switch coupled to the first input and the second input of the amplifier, the third switch is configured to establish a second conduction path between the first input and the second input of the amplifier in response to a second control signal. The apparatus further comprises a fourth switch coupled to the first input and the output of the amplifier. The second transistor comprises an emitter terminal coupled to the input terminal. The second circuit is configured to limit a direct current (DC) voltage level applied to the input terminal in response to a voltage stress condition.

According to another embodiment, the subject technology provides an apparatus that comprises an input terminal configured to receive an input signal. The apparatus further comprises a first circuit coupled to the input terminal, the first circuit comprising: a first transistor coupled to the input terminal; and a level-shifter coupled to the first transistor and configured to provide a first bias voltage to the first transistor. The apparatus further comprises a second circuit coupled to the first circuit, the second circuit comprising a second transistor, the second transistor comprising a base terminal coupled to a first supply voltage. The apparatus further comprises a first switch coupled to the input terminal and a ground potential, the first switch being configured to establish a first conduction path between the input terminal and the ground potential in response to a first control signal. The apparatus further comprises an amplifier comprising a first input and an output, the amplifier being configured to generate an output signal by amplifying the input signal. The apparatus further comprises an output terminal coupled to the output of the amplifier, the output terminal being configured to provide the output signal.

Implementations may include one or more of the following features. The apparatus further comprises a second switch coupled to the input terminal and the first input of the amplifier. The first transistor is coupled to the input terminal and a first node, the level-shifter is configured to provide a first voltage at the first node, and the first voltage is greater than a second voltage at the input terminal by a first offset. The first circuit is configured to conduct a transient current between the input terminal and the first node in response to a voltage transient event. The first switch comprises a third transistor comprising a bulk terminal coupled to the first supply voltage. The second transistor comprises an emitter terminal coupled to the input terminal. The second circuit is configured to limit a direct current (DC) voltage level applied to the input terminal in response to a voltage stress condition.

According to yet another embodiment, the subject technology provides an apparatus, which comprises an input terminal configured to receive an input signal. The apparatus further comprises a first circuit coupled to the input terminal, the first circuit comprising a first transistor coupled to the input terminal and a first node. The first circuit is configured to conduct a transient current between the input terminal and the first node in response to a voltage transient event. The apparatus further comprises a second circuit coupled to the first circuit, the second circuit comprising a second transistor, the second transistor comprising a base terminal coupled to a first supply voltage. The apparatus further comprises a first switch coupled to the input terminal and a ground potential, the first switch being configured to establish a first conduction path between the input terminal and the ground potential in response to a first control signal. The apparatus further comprises an amplifier comprising a first input and an output, the amplifier being configured to generate an output signal by amplifying the input signal. The apparatus further comprises a second switch coupled to the input terminal and the first input of the amplifier. The apparatus further comprises an output terminal coupled to the output of the amplifier, the output terminal being configured to provide the output signal. In various embodiments, the first circuit further comprises a level-shifter coupled to the first transistor and configured to provide a first bias voltage to the first transistor. The first transistor is coupled to the input terminal and the first node, the level-shifter is configured to provide a first voltage at the first node, the first voltage is greater than a second voltage at the input terminal by a first offset. The first switch comprises a third transistor comprising a bulk terminal coupled to the first supply voltage.

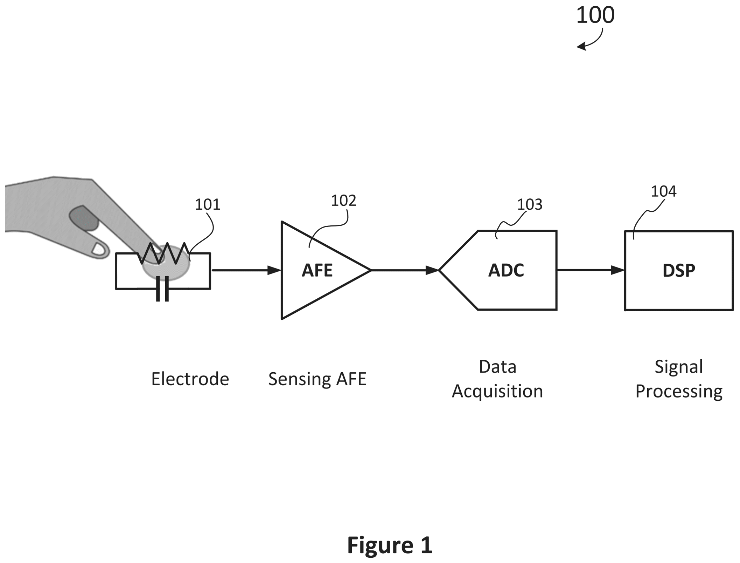

Figure 1 is a block diagram illustrating a signal acquisition system 100, in accordance with various embodiments of the subject technology. This diagram merely provides an example, which should not unduly limit the scope of the claims. One of ordinary skill in the art would recognize many variations, alternatives, and modifications.

System 100 may be implemented in a wide range of applications that require the acquisition and processing of electrical signals, such as bio-sensing systems, industrial monitoring, environmental sensing, and/or the like. For example, in bio-sensing applications, system 100 may be used to acquire electrophysiological signals such as electrocardiography (ECG), electromyography (EMG), electroencephalography (EEG), and/or other biomedical signals for health monitoring. In these applications, system 100 may be used to acquire, condition, and/or process weak electrical signals from an external source and convert them into a digital format suitable for further analysis. As shown in Figure 1, system 100 includes at least one of an electrode 101, an analog front-end (AFE) circuit 102, an analog-to-digital converter (ADC) 103, a processing unit 104, and/or the like.

In various implementations, electrode 101 may be configured to interface with biological tissue to detect electrophysiological signals. Electrode 101 may include various types of electrodes, such as wet electrodes, dry electrodes, capacitive electrodes, and/or the like. For example, in wearable health monitoring applications, a dry electrode may be used due to its ease of use, long-term stability, and biocompatibility. However, dry electrodes have relatively poor electrical conductance, which is largely influenced by the compact size of the electrode and the variable contact conditions between the electrode and the skin. The equivalent source impedance of a dry electrode may be modeled as a parallel resistance-capacitance (RC) network, with resistance values reaching tens of megaohms (MΩ) and capacitance values in the hundreds of picofarads (pF). Such high source impedance presents challenges for subsequent signal processing, as it can lead to attenuated signals, increased susceptibility to interference, and non-ideal leakage paths.

To address the challenges posed by high-impedance electrodes (e.g., electrode 101), AFE circuit 102 may be used to condition the acquired signal before further processing. Given the high source impedance of electrode 101, AFE circuit 102 must exhibit an extremely high input impedance-such as in the gigaohm (GΩ) range-to prevent signal attenuation and distortion. In addition, AFE circuit 102 must minimize input leakage current, as leakage can contribute to signal degradation by introducing shot noise and unwanted voltage offsets. For example, the term "leakage current" may refer to an unintended flow of current through parasitic paths within a circuit, which may arise due to various reasons such as transistor leakage, finite insulation resistance, or unwanted conduction paths between circuit nodes. Excessive leakage may result in non-linear distortion due to signal-dependent leakage paths, compromising signal integrity. In addition to the signal acquisition, AFE circuit 102 must also minimize unpowered leakage currents in the nanoampere (nA) range to prevent interference with other sensing modules and ensure electrical safety. Accordingly, it is desirable for AFE circuit 102 to provide a conditioned output signal that preserves the fidelity of the original input signal while minimizing leakage, non-linearity, and unwanted noise.

In some embodiments, ADC 103 may be coupled to AFE circuit 102 and configured to convert the conditioned output signal from AFE circuit 102 into a digital representation for further processing. The conversion process may include sampling, quantization, and filtering, ensuring that the digitized data retains the key characteristics of the original input signal. In some cases, ADC 103 may be implemented with high resolution and low noise characteristics to preserve signal integrity.

In various examples, processing unit 104 may be coupled to ADC 103 and configured to receive the digital output signal from ADC 103 and perform various signal processing functions, such as filtering, baseline drift correction, signal normalization, feature extraction, and/or the like. This processing enhances the usability of the acquired biosignals for downstream applications, such as heart rate monitoring, arrhythmia detection, or other biomedical analyses. Depending on the application, processing unit 104 may be implemented using a digital signal processor (DSP), a microcontroller, an application-specific integrated circuit (ASIC), a general-purpose processor, and/or the like.

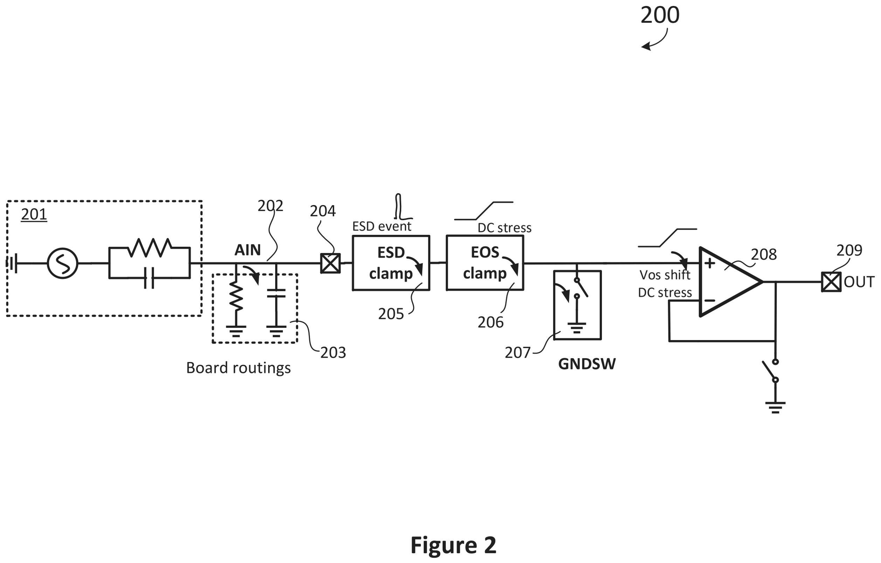

Figure 2 is a circuit diagram illustrating leakage sources in an analog front-end (AFE) circuit 200, in accordance with various embodiments of the subject technology. This diagram merely provides an example, which should not unduly limit the scope of the claims. One of ordinary skill in the art would recognize many variations, alternatives, and modifications. In various implementations, AFE circuit 200 may be part of a signal acquisition system (e.g., system 100 of Figure 1) and may be configured to condition the acquired signal for further processing. However, AFE circuit 200 may suffer from leakage currents in both power-on and power-off conditions, which can introduce noise, signal attenuation, and non-linearity effects that degrade measurement accuracy. Leakage in circuit 200 may originate from various sources, such as board trace leakage, electrostatic discharge (ESD) leakage, electrical overstress (EOS) clamp leakage, termination ground switch (GNDSW) leakage, front-end amplifier leakage, and/or the like.

In some embodiments, circuit 200 may receive an input signal from electrode 201, which may be configured to detect and acquire weak analog signals (e.g., biosignals). Depending on the application, electrode 201 may be implemented as a bio-sensing electrode, a capacitive sensor, or another type of transducer configured to interface with a high-impedance source. The acquired signal may be a low-amplitude analog voltage, which is then transmitted to circuit 200 for conditioning and amplification.

In some examples, the signal from electrode 201 may be transmitted through input trace 202, which may represent the physical conductive path between electrode 201 and AFE circuit 200. However, input trace 202 trace is susceptible to leakage currents due to finite insulation resistance and parasitic coupling with neighboring printed circuit board (PCB) traces. For example, board routings 203 may contribute to leakage by providing unintended conductive paths that may divert part of the signal current, leading to signal degradation. Additionally, parasitic capacitances associated with board routings can attenuate the input signal and introduce unwanted frequency-dependent effects.

In various implementations, AFE circuit 200 may include input terminal 204, which may be configured to receive the input terminal from electrode 201. For instance, the term "input terminal" may refer to a physical or electrical interface within an electronic circuit that is configured to receive an electrical signal or power from an external source. Input terminals may include, without limitation, electrical connectors, pins, pads, ports, sockets, and/or any other physical or virtual interfaces.

According to some embodiments, AFE circuit 200 may include electrostatic discharge (ESD) circuit 205, which may be configured to suppress high-voltage transient events caused by sudden static electricity discharges. For example, the term "electrostatic discharge" may refer to a rapid transfer of electrical charge between two objects with different electrostatic potentials. ESD events may generate voltage spikes that far exceed the breakdown voltage of semiconductor components, leading to signal degradation or device failure. To prevent such failures, ESD circuit 205 may be implemented to clamp excessive voltage spikes and provide a controlled discharge path for transient currents.

In various implementations, ESD circuit 205 may include diodes, transient voltage suppression (TVS) components, thyristors, or other protection circuits that act as a controlled discharge path, redirecting excess charge away from critical circuit nodes. For example, ESD circuit 205 may employ diodes and snap-back NMOS transistors for positive ESD strikes and silicon-controlled rectifier (SCR) diodes for negative ESD strikes. While these designs effectively provide back-power protection-ensuring minimal leakage when power is off-their bulk leakage currents remain non-negligible during operation, particularly in high-impedance sensing applications. Additionally, the non-linear junction capacitances between the input node and the bulk nodes may introduce significant signal distortion and limit system linearity, which may degrade precision below 10-bit resolution.

According to some embodiments, AFE circuit 200 may include an electrical overstress (EOS) circuit 206, which may be configured to limit excessive direct current (DC) voltage levels at input terminal 204 and protect the front-end circuit from long-duration voltage stress conditions. For example, the term "electrical overstress" may refer to a condition in which an excessive voltage or current is applied to an electronic component beyond its specified operating limits for an extended duration. EOS events may occur due to miswiring, voltage transients, or improper power sequencing, potentially leading to degradation or failure. Additionally, EOS conditions can persist over time, gradually damaging input transistors or shifting the DC operating point of the circuit.

In various implementations, EOS circuit 206 may utilize series-connected diodes referenced to the chip ground to clamp excessive voltage levels. For instance, these diodes may be implemented using bipolar junction transistors (BJTs) connected in a Darlington structure. The Darlington configuration provides a high-gain clamping effect, allowing EOS circuit 206 to rapidly respond to overvoltage conditions and limit the maximum DC voltage applied to the input terminal. However, the amplified base current in the Darlington structure increases exponentially with the number of diodes in series. As a result, the total leakage current of EOS circuit 206 can become significant, introducing an unwanted current path that distorts the input signal and degrades measurement accuracy.

In some embodiments, AFE circuit 200 may further include a ground switch (GNDSW) 207, which may be configured to reset the electrode voltage and establish a discharge path to the ground under specific operating conditions. For example, the term "ground switch" may refer to a switching element that selectively connects an input node to a reference potential (e.g., ground). In various implementations, ground switch 207 remains open during normal signal acquisition to allow AFE circuit 200 to receive high-impedance signals without interference. However, during power-down states, calibration phases, or reset conditions, ground switch 207 transitions to a closed state, providing a controlled discharge path that prevents floating potentials and stabilizes the sensor input.

In some implementations, ground switch 207 may utilize a back-to-back connected switch configuration to provide bi-directional voltage blocking, ensuring that the switch does not inadvertently conduct when it is in the off state. This configuration allows ground switch 207 to accommodate both positive and negative voltage swings, which is beneficial for handling AC-coupled bioelectrical signals. However, at the zero-crossing point of the input signal, the body diodes of the two transistors are weakly conducting, resulting in a temporary drop in the equivalent off-state impedance. This dip in off-impedance near the zero-crossing may degrade signal linearity, introducing distortion that affects precision measurements.

According to various embodiments, AFE circuit 200 may further include amplifier 208, which may be configured to amplify the acquired input signal for further processing. For example, the term "amplifier" may refer to an electronic circuit that increases the amplitude of an input signal while preserving its key characteristics, such as frequency content and waveform integrity. Examples of amplifiers may include, without limitation, low-noise amplifiers (LNAs), operational amplifiers (op-amps), variable-gain amplifiers (VGAs), and/or the like. However, electrical overstress applied to amplifier 208 during power-off conditions can lead to offset shifts over time due to device aging. As semiconductor devices experience repeated stress cycles, gradual degradation in transistor characteristics can result in a mismatch between differential input pairs, causing undesired DC offsets at the amplifier output. Additionally, leakage currents in the front-end circuit may further contribute to offset drift, reducing long-term accuracy in precision sensing applications.

In some examples, AFE circuit 200 may further include output terminal 209, which may be configured to provide the amplified signal from amplifier 208 to subsequent processing stages. For instance, the term "output terminal" may refer to a physical or electrical interface within an electronic circuit that is configured to transmit an electrical signal or power to an external component. Output terminals may include, without limitation, electrical connectors, pins, pads, ports, sockets, and/or any other physical or virtual interfaces.

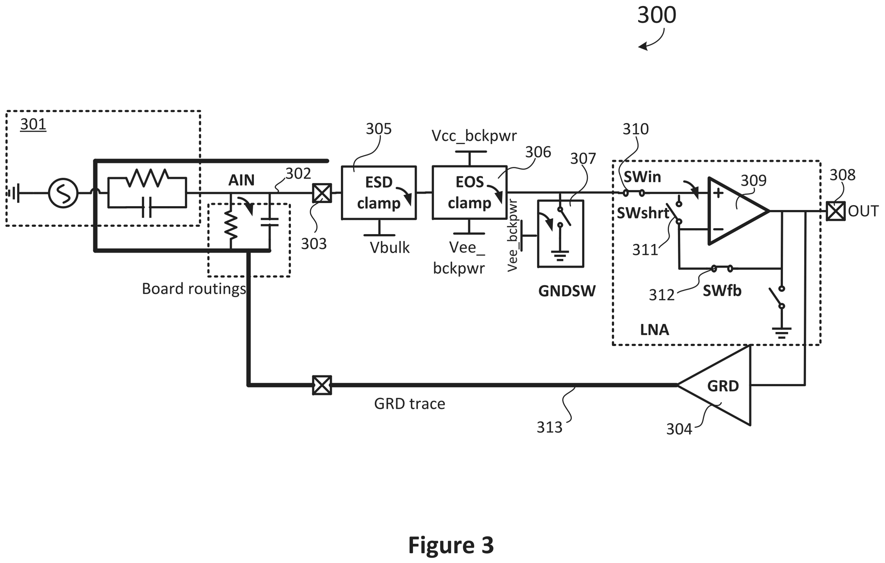

Figure 3 is a circuit diagram illustrating an analog front-end (AFE) circuit 300 for minimizing leakage, in accordance with various embodiments of the subject technology. This diagram merely provides an example, which should not unduly limit the scope of the claims. One of ordinary skill in the art would recognize many variations, alternatives, and modifications. Similar to AFE circuit 200 in Figure 2, AFE circuit 300 may be part of a signal acquisition system (e.g., system 100 of Figure 1) and may be configured to condition an acquired input signal for further processing. In some examples, AFE circuit 300 implements various enhancements aimed at mitigating leakage issues originating from ESD circuits, EOS circuits, termination ground switches, and/or front-end amplifiers, thereby improving signal integrity and linearity.

In some embodiments, input terminal 303 may receive an input signal from electrode 301, which may be configured to detect weak analog signals. The acquired signal may be transmitted through input trace 302, which, as previously described, may suffer from leakage currents due to finite insulation resistance and parasitic coupling. To mitigate these issues, AFE circuit 300 may further include guard buffer 304, which may be configured to drive guard traces 313 surrounding input trace 302. By actively controlling the potential of the surrounding traces, guard buffer 304 minimizes voltage differences across insulation resistances, thereby reducing unwanted leakage currents. Additionally, guard buffer 304 helps avoid signal attenuation by canceling out the effects of input parasitic capacitance and increasing the input impedance within the signal band of interest.

In various embodiments, ESD circuit 305 may adopt a shifted bulk bias technique to reduce leakage currents. For instance, ESD circuit 305 may apply a bulk biasing scheme (e.g., Vbulk) that maintains a more stable reverse bias condition, thereby suppressing unwanted leakage while preserving the electrostatic protection function. In some examples, EOS circuit 306 may incorporate a guard bias with back-powered supply rails (e.g., Vcc_bckpwr and/or Vee_bckpwr), ensuring that EOS circuit 306 maintains a low leakage profile while effectively regulating excessive DC stress conditions.

In some embodiments, ground switch 307 may be implemented as a three-diode series configuration referenced to a back-powered negative rail (e.g., Vee_bckpwr). This configuration ensures that at any input voltage, at least one junction remains strongly reverse-biased, thereby minimizing leakage in power-off conditions.

In some implementations, AFE circuit 300 may further include a set of series switches, which may be configured to mitigate leakage, offset shifts, and stabilize the front-end amplifier (e.g., amplifier 309) under different operating conditions. In some examples, switch 311 (e.g., SWshrt) may be configured to short-circuit the input and output of amplifier 309 in power-off conditions. By connecting the input and output of amplifier 309, switch 311 helps balance stress across the input differential pair, thereby mitigating long-term offset shifts caused by device aging.

In various embodiments, AFE circuit 300 may further incorporate an isolation mechanism to avoid power-off input leakage from the output of amplifier 309. For instance, AFE circuit 300 may further include switch 310 (e.g., SWin) and switch 312 (e.g., SWfb). Switch 310 may be coupled to input terminal 303 and the input of amplifier 309. Switch 312 may be positioned in a feedback loop of amplifier 309. During power-off states, switches 310 and 312 may be opened, effectively isolating input terminal 307 and the feedback network from unwanted leakage currents originating from the amplifier's output stage. In some examples, AFE circuit 300 may further include output terminal 308, which may be configured to provide the amplified signal from amplifier 309 to subsequent processing stages.

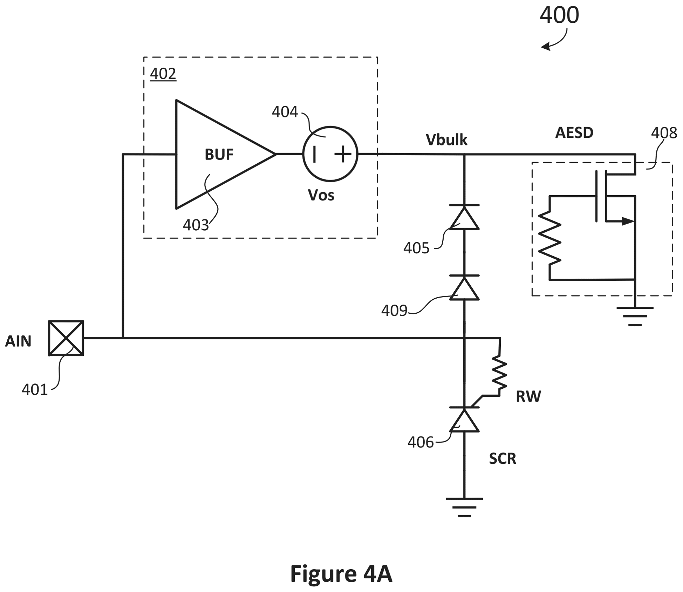

Figure 4A is a circuit diagram illustrating an electrostatic discharge (ESD) protection circuit 400, in accordance with various embodiments of the subject technology. This diagram merely provides an example, which should not unduly limit the scope of the claims. One of ordinary skill in the art would recognize many variations, alternatives, and modifications. In various implementations, system 400 may be part of an AFE circuit (e.g., ESD clamp 305 of Figure 3) and configured to protect sensitive input terminals from transient voltage spikes caused by ESD events. For instance, ESD circuit 400 may function as a clamping mechanism that limits excessive voltages at the input, ensuring that downstream circuitry remains within safe operating conditions.

In some embodiments, system 400 may include input terminal 401, which may be configured to receive an input signal. The input signal may be a low-amplitude analog voltage acquired from a sensing electrode, a capacitive sensor, or another high-impedance signal source. For example, in a bio-sensing application, input terminal 401 may receive a biosignal from a dry electrode for electrophysiological measurements.

To provide ESD protection, circuit 400 may include diode 405 and/or 409, transistor 408 and/or silicon-controlled rectifier (SCR) 406, which work together to suppress transient voltage spikes. For instance, the term "transistor" may refer to a semiconductor device that controls the flow of electricity in electronic circuits. Examples of transistors may include, without limitation, bipolar junction transistors (BJTs), metal-oxide-semiconductor field-effect transistors (MOSFETs), junction field-effect transistors (JFETs), and/or the like. In some examples, transistor 408 may be implemented as an NMOS snapped-back transistor. For instance, transistor 408 operates in a self-triggered mode, where an overvoltage event forces the device into a breakdown and then bipolar conducting region, allowing it to dissipate excess charge and limit the voltage applied to downstream circuitry. Transistor 408 may be configured to protect against positive ESD strikes by conducting transient current away from sensitive circuit components when an excessive voltage is applied to input terminal 401.

In some embodiments, SCR 406 may be configured to provide a controlled discharge path for negative ESD strikes. For example, the term "silicon-controlled rectifier" may refer to a four-layer semiconductor device designed to control high-power electrical currents. SCR 406 may operate as a latching switch, remaining in a high-impedance state under normal conditions and transitioning to a low-impedance conducting state when triggered by an overvoltage event. In some cases, transistor 408 may be coupled to the AESD node, which serves as an intermediate junction between the input terminal 401 and the protective discharge path. SCR 406 may be coupled to the ground node, which serves as a reference for negative ESD clamping.

In various examples, circuit 400 may include diodes 405 and 409, which may be configured to regulate voltage levels and control current flow at AESD nodes. For example, diode 405 may be coupled to the AESD node and may function as a voltage-limiting element, ensuring that excessive voltage at the AESD node is clamped within a safe range. In some aspects, a resistor may be coupled between the AIN and RW nodes, providing a defined voltage drop to control the triggering behavior of SCR 406.

However, the configuration of transistor 408 and SCR 406 can introduce bulk leakage currents and nonlinear capacitance effects at the AESD node. In high-impedance sensing applications, even small leakage currents can degrade signal integrity, while variations in junction capacitance may lead to nonlinear distortions, reducing overall system precision. To protect sensitive downstream circuitry, circuit 400 may implement a boot-strapped biasing mechanism to regulate the voltages at certain ESD protection nodes (e.g., AESD node), thereby ensuring optimal biasing conditions to mitigate leakage and non-linearity effects.

According to some embodiments, circuit 400 may further include level-shifter 402, which may be configured to regulate the biasing conditions of transistor 408 and SCR 406. For instance, the term "level-shifter" may refer to an electronic circuit or device used to convert a signal from one voltage level to another. For instance, level-shifter 402 may be configured to maintain a controlled bias at AESD node to ensure that the junctions remain in a stable reverse-biased state under normal operating conditions, minimizing leakage currents and improving signal fidelity.

In various examples, level-shifter 402 may include buffer 403, which may be coupled to input terminal 401. The term "buffer" may refer to an electronic circuit or component used to isolate and/or stabilize a signal while maintaining its integrity. Examples of buffers may include, without limitation, voltage followers, unity-gain buffers, source followers, and/or the like. For instance, buffer 403 may receive the input signal from input terminal 401 and generate a stabilized, high-impedance version of the signal, preventing direct loading effects on the input source.

In some implementations, level-shifter 402 may further include voltage generator 404, which may be coupled to the AESD node. For example, the term "voltage generator" may refer to an electronic circuit that produces a stable voltage output, which may be fixed or adjustable, depending on the implementation. Examples of voltage generators may include, without limitation, DC bias circuits, charge pumps, voltage regulators, transistor-based reference generators, and/or the like. In some cases, voltage generator 404 may be configured to add an offset voltage (e.g., Vos) to the buffered input signal, thereby shifting the biasing voltage of the AESD node to ensure proper reverse biasing of the ESD protection components (e.g., transistor 408 and/or SCR 406). By adjusting the voltage applied to AESD node, voltage generator 404 helps regulate the voltage drop across the PN junctions, preventing excessive variations that could lead to increased junction leakage. Additionally, maintaining a consistent potential difference across the diodes reduces their nonlinear capacitance effects, which could otherwise cause signal-dependent distortions.

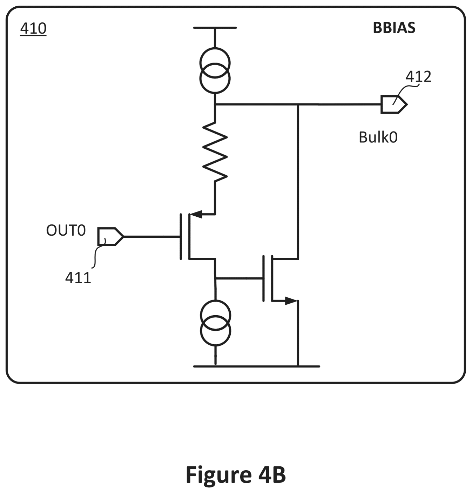

Figure 4B is a circuit diagram illustrating a level-shifter 410 of an electrostatic discharge (ESD) protection circuit, in accordance with various embodiments of the subject technology. This diagram merely provides an example, which should not unduly limit the scope of the claims. One of ordinary skill in the art would recognize many variations, alternatives, and modifications. In various implementations, level-shifter 410 may be part of an ESD protection circuit (e.g., ESD circuit 400 of Figure 4A) and configured to provide a stable bias voltage with high input impedance and low leakage. For example, level-shifter 410 may be implemented as a gate input level-shifter and configured to regulate the bulk voltage of the ESD protection components (e.g., transistor 408 and SCR 406 of Figure 4A).

In some embodiments, level-shifter 410 may receive a buffered input signal (e.g., generated by buffer 403 of Figure 4A) at terminal 411 and generate a bias voltage at terminal 412. For example, the term "bias voltage" may refer to a steady-state voltage applied to a circuit element to establish its operating condition. Bias voltages may be used to set the operating point of active components, regulate transistor conduction states, and stabilize circuit behavior.

In some examples, terminal 412 may be coupled to the AESD node in Figure 4A and configured to provide the bias voltage to ensure that these nodes remain in a controlled reverse-biased state. By maintaining proper biasing conditions, level-shifter 410 helps regulate the voltage drop across the PN junctions, thereby reducing bulk leakage currents and mitigating nonlinear junction capacitance effects that could otherwise degrade signal integrity. The output bias voltage tracks the input signal with an offset voltage, ensuring that the junction diodes maintain a stable potential difference, which helps suppress variations in leakage current and enhances the overall ESD protection performance. In some cases, level-shifter 410 may employ a power-efficient super source follower, which extends the level-shifter bandwidth while maintaining low power consumption.

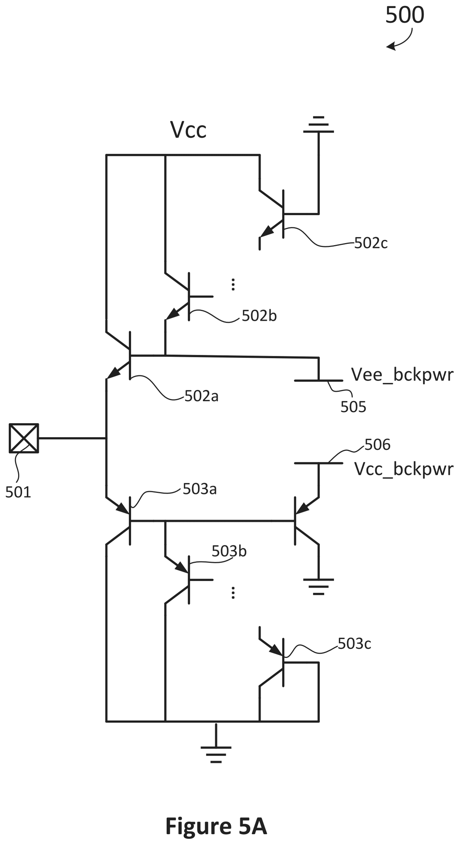

Figure 5A is a circuit diagram illustrating an electrical overstress (EOS) protection circuit 500, in accordance with various embodiments of the subject technology. This diagram merely provides an example, which should not unduly limit the scope of the claims. One of ordinary skill in the art would recognize many variations, alternatives, and modifications. In various implementations, circuit 500 may be part of an AFE circuit (e.g., EOS clamp 306 of Figure 3) and configured to protect sensitive input terminals from excessive DC voltage stress, which could otherwise degrade device reliability and introduce performance degradation over time.

In some embodiments, circuit 500 may include input terminal 501, which may be configured to receive an input signal. The input signal may be a low-amplitude analog voltage acquired from a sensing electrode, a capacitive sensor, or another high-impedance signal source. For example, in a bio-sensing application, input terminal 501 may receive a biosignal from a dry electrode for electrophysiological measurements.

To mitigate EOS effects, circuit 500 may include a plurality of transistors configured to regulate voltage stress and prevent excessive current flow into the sensitive front-end circuitry. For example, circuit 500 may include a plurality of BJTs (e.g., BJTs 502a-c, 503a-c) configured in a Darlington structure to establish a series of clamping elements. In some examples, BJTs 502a-c may be coupled in series with their collectors connected to a positive supply rail (e.g., Vcc), and their emitters are connected to successive transistor bases, forming a cascading amplification path. For instance, the emitter of BJT 502b may be coupled to the base of BJT 502a. The term "base" or "base terminal" may refer to an electrical node of a transistor or other semiconductor device that is configured to control its operation. Depending on the implementation, the base terminal may serve as a control input that regulates current flow between other terminals. The emitter of BJT 502a may be coupled to input terminal 501. Similarly, BJTs 503a-c may be arranged with their collectors coupled to a reference potential (e.g., ground), and their emitters form a series connection leading toward the regulated clamping node. This structure enables a stepped voltage clamping mechanism, allowing circuit 500 to limit the maximum DC voltage applied to input terminal 501 by providing a controlled discharge path to the ground.

However, while the Darlington structure provides effective EOS clamping, it also introduces drawbacks related to leakage currents. For instance, the base currents of the BJTs are amplified through the cascaded stages, where the amplified base current increases exponentially with the number of diodes in series. These leakage currents are particularly problematic in high-impedance sensing applications, where even minor leakage variations can introduce nonlinearity and degrade measurement accuracy.

To address these issues, circuit 500 employs a back-power-protected biasing scheme to regulate the voltage levels at the bases of the BJTs and mitigate leakage amplification effects. As an example, circuit 500 includes negative supply rail 505 (e.g., Vee_bckpwr) and positive supply rail 506 (e.g., Vcc_bckpwr). The bases of BJTs directly connected to input terminal 501 may be biased by supply rails 505 and/or 506, ensuring that the PN junctions remain reverse-biased under normal operation. By maintaining a stable bias voltage, the back-power-protected supply prevents the exponential amplification of leakage currents that would otherwise occur due to the Darlington structure. Additionally, supply rails 505 and 506 may absorb emitter leakage currents from the subsequent BJTs in the cascade, effectively isolating input terminal 501 from unwanted leakage effects.

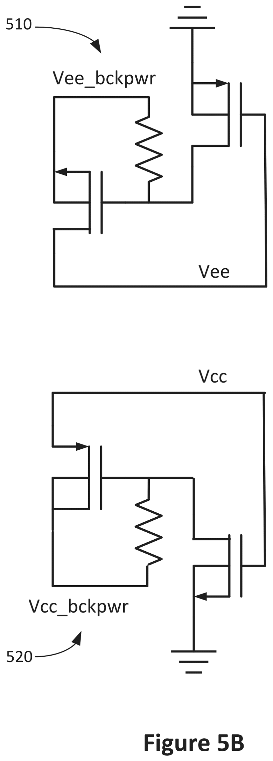

Figure 5B is a circuit diagram illustrating back-power protection switches of an electrical overstress (EOS) protection circuit, in accordance with various embodiments of the subject technology. This diagram merely provides an example, which should not unduly limit the scope of the claims. One of ordinary skill in the art would recognize many variations, alternatives, and modifications. In various implementations, back-power protection switches 510 and 520 may be part of an EOS protection circuit (e.g., EOS circuit 500 of Figure 5A) and configured to regulate power supply connections (e.g., supply rails 505 and/or 506), ensuring low leakage operation under both normal and power-off conditions.

In some embodiments, switch 510 may be configured to regulate a negative supply voltage (e.g., Vee _bckpwr). Switch 520 may be configured to regulate a positive supply voltage (e.g., Vcc_bckpwr). For instance, switch 510 may be coupled between a main negative supply rail (e.g., Vee) and Vee_bckpwr. Switch 520 may be coupled between a main positive supply rail (e.g., Vcc) and Vcc_bckpwr. When power is off, switches 510 and 520 isolate Vee_bckpwr and Vcc_bckpwr from unintended leakage paths, thereby preventing excessive leakage currents that could degrade system performance.

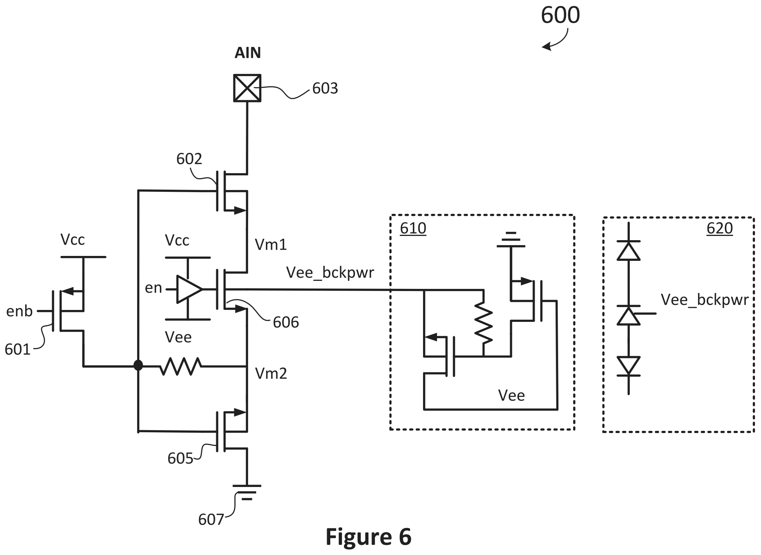

Figure 6 is a circuit diagram illustrating a ground switch 600, in accordance with various embodiments of the subject technology. This diagram merely provides an example, which should not unduly limit the scope of the claims. One of ordinary skill in the art would recognize many variations, alternatives, and modifications.

In various implementations, ground switch 600 may be part of an AFE circuit (e.g., GNDSW 307 of Figure 3) and configured to reset the electrode voltage under specific conditions. For example, ground switch 600 may remain open during normal operation when input signals are acquired to allow high-impedance signal sensing. However, under certain conditions, such as power-down states or system resets, ground switch 600 may transition to a closed state, discharging the electrode voltage to a reference potential (e.g., ground 607) and preventing residual charge accumulation.

In some embodiments, ground switch 600 may include input terminal 603 (e.g., AIN), which may be configured to receive an input signal. Transistor 602 may be coupled to input terminal 603 and configured to control the discharge path for resetting the electrode voltage. In some cases, transistor 602 may be implemented as a switching element, enabling or disabling the connection between input terminal 603 and the reference ground potential (e.g., ground 607). During normal operation, transistor 602 remains off, allowing the system to sense signals without interference. When ground switch 600 is activated, transistor 602 transitions to an on-state, providing a controlled discharge path.

According to various implementations, transistor 605 may be coupled in series with transistor 602. For instance, transistors 602 and 605 may be configured as a back-to-back connected switch-where the body diodes of the two transistors oppose each other-to provide bi-directional voltage blocking. Under normal conditions, transistor 605 remains off, maintaining high impedance to isolate input terminal 603. When a discharge is required (e.g., during system resets), transistor 605 is turned on, allowing residual charge to be safely discharged to ground 607.

In some implementations, ground switch 600 may further include transistor 601, which may be configured to control the activation or deactivation of ground switch 600. For instance, transistor 601 may be controlled by an external enable signal (e.g., enb) that dictates whether ground switch 600 should be in an active or inactive state. When an enable signal is applied, transistor 601 regulates the gate voltage of transistors 602 and/or 605, thereby facilitating the activation of the discharge path.

In various embodiments, ground switch 600 may further include transistor 606 to improve off-state impedance and enhance zero-crossing linearity. Transistor 606 may be connected in series with transistors 602 and 605. For instance, the source terminal of transistor 602 may be coupled to the drain terminal of transistor 606, and the source terminal of transistor 606 may be coupled to the source terminal of transistor 605. In some cases, the bulk of transistor 606 may be biased by a negative supply voltage (e.g., Vee_bckpwr) generated by circuit 610 to maintain a reverse bias across its junctions, ensuring that at any input voltage, at least one PN junction remains in a reverse-biased state. This configuration prevents leakage currents from increasing at low-voltage crossings, improving the off-state impedance around 0V input.

In some examples, circuit 620 represents a simplified model of ground switch 600, illustrating a three-diode configuration in which the middle transistor is biased by a negative supply voltage (e.g., Vee _bckpwr). This negative bias ensures that at least one PN junction remains strongly reverse-biased at any input voltage, thereby enhancing the off-state impedance and minimizing leakage currents.

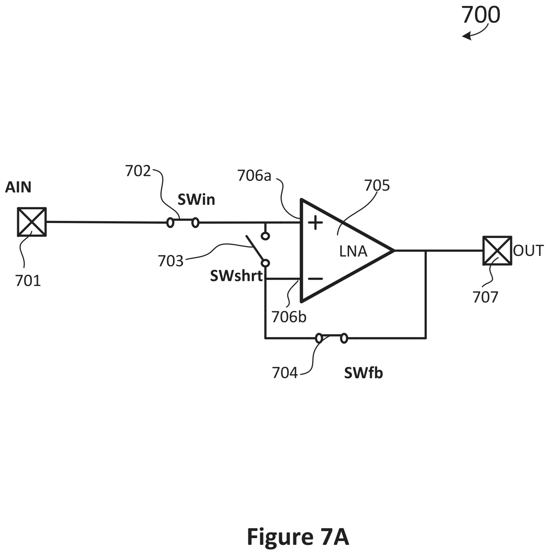

Figure 7A is a circuit diagram illustrating a series switch system 700, in accordance with various embodiments of the subject technology. This diagram merely provides an example, which should not unduly limit the scope of the claims. One of ordinary skill in the art would recognize many variations, alternatives, and modifications.

In some embodiments, system 700 may include input terminal 701 (e.g., AIN), which may be configured to receive an input signal. In some examples, switch 703 (e.g., SWshrt) may be coupled to an input of amplifier 705. For instance, switch 703 may be coupled to first input 706a and/or second input 706b of amplifier 705. In some cases, first input 706a may be a non-inverting input, and second input 706b may be an inverting input. Switch 703 may be configured to short the input and output of amplifier 705 when the system is in a power-off state. This helps balance the stress across the input differential pair of the amplifier, thereby mitigating long-term offset shifts caused by device aging under DC stress.

However, the presence of switch 703 may introduce potential leakage concerns. Since the output of amplifier 705 is not a high-impedance node, unwanted leakage currents may flow from the amplifier's output back into the input path. In some implementations, system 700 may further incorporate an isolation mechanism to avoid power-off input leakage from the output of amplifier 705. For instance, system 700 may further include switch 702 (e.g., SWin) and switch 704 (e.g., SWfb). Switch 702 may be coupled to input terminal 701 and first input 706a of amplifier 705. Switch 704 may be positioned in a feedback loop of amplifier 705. During power-off states, switches 702 and 704 may be opened, effectively isolating input terminal 701 and the feedback network from unwanted leakage currents originating from the amplifier's output stage. In some examples, system 700 may further include output terminal 707, which may be configured to provide the amplified signal from amplifier 705 to subsequent processing stages.

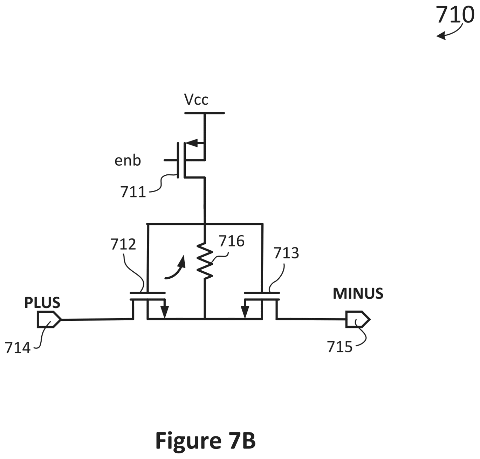

Figure 7B is a circuit diagram illustrating series switch 710, in accordance with various embodiments of the subject technology. This diagram merely provides an example, which should not unduly limit the scope of the claims. One of ordinary skill in the art would recognize many variations, alternatives, and modifications. In various implementations, series switch 710 may be part of a series switch system (e.g., system 700 of Figure 7A) configured to provide bi-directional voltage blocking for input signal isolation in an AFE circuit. In some examples, series switch 710 may include first terminal 714 (e.g., PLUS) and second terminal 715 (e.g., MINUS), which may be configured to receive differential signals.

According to some embodiments, series switch 710 may include a back-to-back transistor configuration, where two switching transistors (e.g., transistors 712 and 713) are coupled in opposing directions between two terminals (e.g., first terminal 714 and second terminal 715). For instance, the drain of transistor 712 may be coupled to first terminal 714, and the drain of transistor 713 may be coupled to second terminal 715. The sources of transistors 712 and 713 may be coupled together at a middle node. In some cases, transistor 711 may be coupled to the gates of transistors 712 and 713 and configured to regulate the conduction state of the series switch 710 by controlling the gate voltages of transistors 712 and 713. For instance, transistor 711 may be controlled by an external enable signal (e.g., enb) that dictates whether series switch 710 should be in an active or inactive state.

To ensure that series switch 710 remains off in power-down conditions, resistor 716 may be coupled between the gate and source of the switching transistors (e.g., transistors 712 and/or 713). Resistor 716 may be configured to short the gate-source voltage (e.g., Vgs), thereby ensuring that the transistors remain in a non-conducting state. However, the middle node of series switch 710 is not inherently tied to a fixed voltage. If the middle node rises above 0V, the resistor 716 may introduce an unintended leakage path from the input signal to the supply rail (e.g., Vcc), leading to leakage currents that could degrade isolation performance.

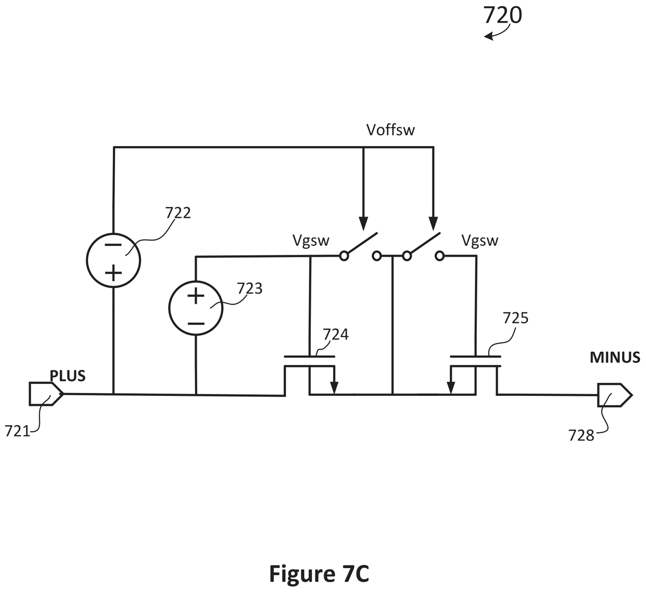

Figure 7C is a circuit diagram illustrating series switch 720, in accordance with various embodiments of the subject technology. This diagram merely provides an example, which should not unduly limit the scope of the claims. One of ordinary skill in the art would recognize many variations, alternatives, and modifications.

In various implementations, series switch 720 may be part of a series switch system (e.g., system 700 of Figure 7A) configured to provide bi-directional voltage blocking for input signal isolation in an AFE circuit. In contrast to series switch 710 of Figure 7B, which employs a passive pass-through resistor (e.g., resistor 716) to control the conduction state of the switch, series switch 720 may utilize a floating battery gate drive mechanism to enhance leakage control during power-off conditions. In some examples, series switch 720 may include first terminal 721 (e.g., PLUS) and second terminal 728 (e.g., MINUS), which may be configured to receive differential signals.

According to some embodiments, series switch 720 may include a back-to-back transistor configuration, where two switching transistors (e.g., transistors 724 and 725) are coupled in opposing directions between two terminals (e.g., first terminal 721 and second terminal 728). For instance, the drain of transistor 724 may be coupled to first terminal 721, and the drain of transistor 725 may be coupled to second terminal 728. The sources of transistors 724 and 725 may be coupled together at a middle node.

To regulate the operation of the back-to-back transistors (e.g., transistors 724 and 725), circuit 720 may implement a floating battery gate drive mechanism, which generates gate voltages based on the terminal voltage of the series switch 720 (e.g., terminal 721 and 728). For example, voltage sources 722 and 723 may generate floating gate drive signals (e.g., Vgsw and Voffsw) to control the conduction state of transistors 724 and 725. By sensing the terminal voltage and applying a positive or negative offset, the floating battery drive ensures that the back-to-back transistors remain properly biased, preventing unintended leakage currents. In some cases, the floating battery may be implemented using a high-input-impedance buffer (e.g., a source follower) or a level shifter to sense the source voltage without drawing current, thereby improving overall isolation performance and ensuring minimal leakage under power-off conditions.

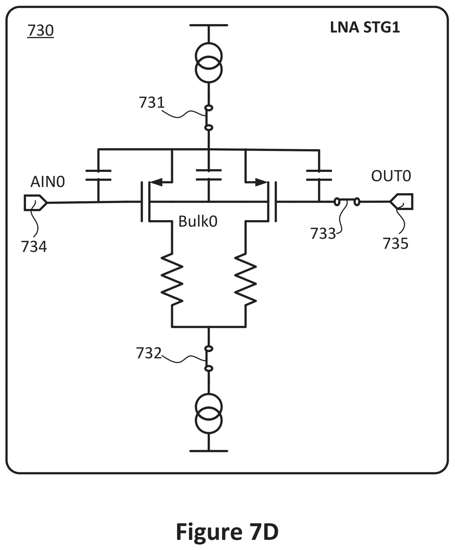

Figure 7D is a circuit diagram illustrating a first stage pre-amplifier 730 of an amplifier, in accordance with various embodiments of the subject technology. This diagram merely provides an example, which should not unduly limit the scope of the claims. One of ordinary skill in the art would recognize many variations, alternatives, and modifications. In some implementations, amplifier 730 may be part of an AFE circuit (e.g., amplifier 309 of Figure 3) or part of an amplifier (e.g., LNA 705 of Figure 7A) and configured to amplify the acquired input signal for further processing. For instance, amplifier 730 receives an input signal at input terminal 734 (e.g., AIN0) and feedback signal at terminal 735 (e.g., OUT0), processes it through an amplifier stage, and outputs the amplified signal at output terminal 707 of Figure 7A.

To mitigate leakage currents at input terminal 734 during power-off conditions, amplifier 730 may include one or more series switches (e.g., switches 731, 732, and 733), which may be coupled to the amplifier input pair's source, drain, bulk, and/or feedback nodes. These series switches may be configured to remain open during power-off conditions to prevent leakage currents from flowing into the input terminals.

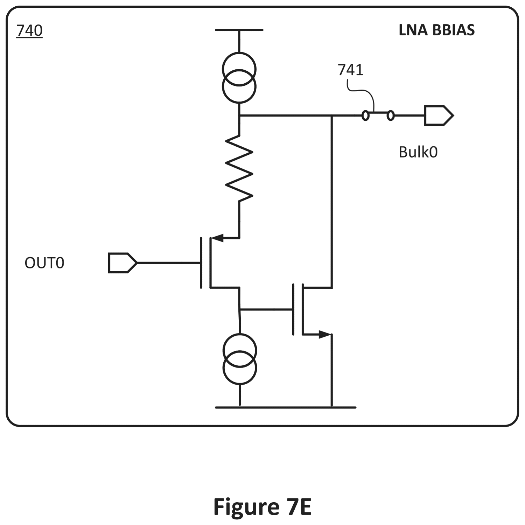

Figure 7E is a circuit diagram illustrating a biasing circuit 740 of an amplifier, in accordance with various embodiments of the subject technology. This diagram merely provides an example, which should not unduly limit the scope of the claims. One of ordinary skill in the art would recognize many variations, alternatives, and modifications.

In some implementations, biasing circuit 740 may be part of an AFE circuit (e.g., amplifier 309 of Figure 3) or part of an amplifier (e.g., LNA 705 of Figure 7A) and configured to regulate the bulk bias voltage (e.g., Bulk0 of Figure 7D) of the amplifier's input transistors. Bulk biasing is beneficial for reducing the parasitic coupling capacitance of the amplifier's input transistors and avoiding signal attenuation with a high-impedance signal source, particularly in applications requiring low-noise and high-precision signal amplification. In some cases, biasing circuit 740 may include series switch 741, which may be implemented as a back-to-back switch to provide bidirectional voltage blocking. During normal operation, series switch 741 remains closed, allowing the biasing voltage to be applied to the bulk of the input transistors. In power-off conditions, series switch 741 transitions to an open state, effectively isolating Bulk0 from the bias network and preventing leakage currents from forming between the bulk node and other circuit elements.

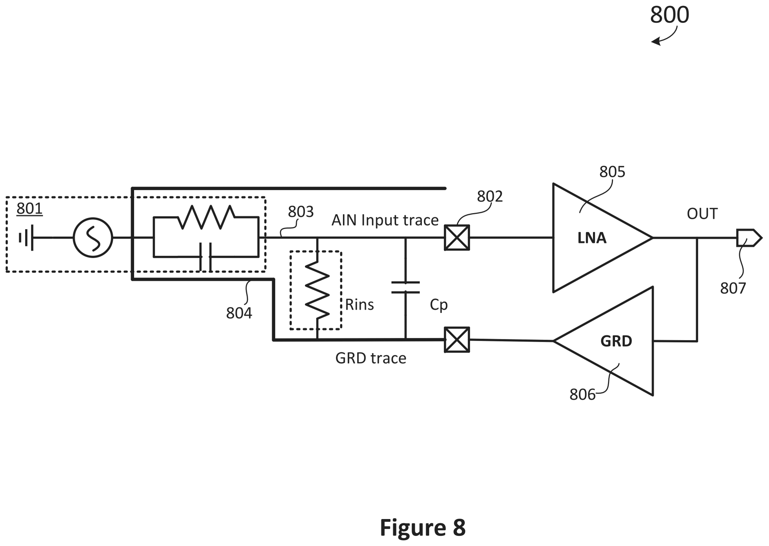

Figure 8 is a circuit diagram illustrating an analog front-end (AFE) circuit 800 with a guard buffer system, in accordance with various embodiments of the subject technology. This diagram merely provides an example, which should not unduly limit the scope of the claims. One of ordinary skill in the art would recognize many variations, alternatives, and modifications.

In some embodiments, input terminal 802 may receive an input signal from electrode 801, which may be configured to detect weak analog signals. The acquired signal may be a low-amplitude analog voltage, such as a biosignal in electrophysiological applications. The input signal may transmitted through input trace 803 to the AFE circuit for processing. However, leakage currents may arise due to finite insulation resistance between the input trace (e.g., AIN input trace) and neighboring PCB traces (e.g., guard trace 804). This insulation resistance (e.g., Rins) forms an unwanted conduction path that allows leakage currents to flow between the input and adjacent PCB traces.

To address these issues, AFE circuit 800 may further include guard buffer 806, which may be configured to drive the guard trace 804 to minimize voltage differentials across the insulation resistance. For instance, guard buffer 806 may be configured to maintain the voltage potential of guard trace 804 close to that of input trace 803, thereby reducing the voltage difference across Rins and effectively minimizing leakage currents. By driving guard trace 804 with a voltage that closely matches input trace 803, AFE circuit 800 ensures that leakage pathways between the traces remain negligible.

In some implementations, guard buffer 806 also helps avoid signal attenuation by mitigating the effects of parasitic capacitance (e.g., Cp). Without the guard buffer, Cp introduces additional loading on the input signal, limiting the high-frequency response of the circuit. By matching the potential at guard trace 804, guard buffer 806 cancels out the capacitive loading effects, thereby increasing the input impedance within the signal band of interest and preserving the high-frequency components of the input signal for better signal-to-noise ratio.

In various embodiments, AFE circuit 800 may further include amplifier 805, which may be configured to amplify the acquired input signal for subsequent processing. For instance, amplifier 805 may be a low-noise amplifier configured to provide high gain while preserving signal integrity. The amplified signal is then transmitted to output terminal 807, which serves as the interface for downstream signal processing stages.

While the above is a full description of the specific embodiments, various modifications, alternative constructions and equivalents may be used. Therefore, the above description and illustrations should not be taken as limiting the scope of the subject technology which is defined by the appended claims.

The invention further comprises the following embodiments forming part of the description:
1. An apparatus comprising:
   an input terminal configured to receive an input signal;
   a first circuit coupled to the input terminal, the first circuit comprising:
      a first transistor coupled to the input terminal; and
      a level-shifter coupled to the first transistor and configured to provide a first bias voltage to the first transistor;
      a second circuit coupled to the first circuit, the second circuit comprising a second transistor, the second transistor comprising a base terminal coupled to a first supply voltage;
      a first switch coupled to the input terminal and a ground potential, the first switch being configured to establish a first conduction path between the input terminal and the ground potential in response to a first control signal;
      an amplifier comprising a first input and an output, the amplifier being configured to generate an output signal by amplifying the input signal;
      a second switch coupled to the input terminal and the first input of the amplifier; and
      an output terminal coupled to the output of the amplifier, the output terminal being configured to provide the output signal.
2. The apparatus of embodiment 1, wherein the first transistor is coupled to the input terminal and a first node, the level-shifter is configured to provide a first voltage at the first node, the first voltage is greater than a second voltage at the input terminal by a first offset.
3. The apparatus of embodiment 2, wherein the level-shifter comprises a voltage generator coupled to the first node, the voltage generator is configured to determine the first offset.
4. The apparatus of embodiment 2, wherein the first circuit is configured to conduct a transient current between the input terminal and the first node in response to a voltage transient event.
5. The apparatus of embodiment 1, wherein the first switch comprises a third transistor comprising a bulk terminal coupled to the first supply voltage.
6. The apparatus of embodiment 1, wherein:
   the amplifier further comprises a second input; and
   the apparatus further comprises a third switch coupled to the first input and the second input of the amplifier, the third switch is configured to establish a second conduction path between the first input and the second input of the amplifier in response to a second control signal.
7. The apparatus of embodiment 6, further comprising a fourth switch coupled to the first input and the output of the amplifier.
8. The apparatus of embodiment 1, wherein the second transistor comprises an emitter terminal coupled to the input terminal.
9. The apparatus of embodiment 1, wherein the second circuit is configured to limit a direct current (DC) voltage level applied to the input terminal in response to a voltage stress condition.
10. An apparatus comprising:
   an input terminal configured to receive an input signal;
   a first circuit coupled to the input terminal, the first circuit comprising:
      a first transistor coupled to the input terminal; and
      a level-shifter coupled to the first transistor and configured to provide a first bias voltage to the first transistor;
      a second circuit coupled to the first circuit, the second circuit comprising a second transistor, the second transistor comprising a base terminal coupled to a first supply voltage;
      a first switch coupled to the input terminal and a ground potential, the first switch being configured to establish a first conduction path between the input terminal and the ground potential in response to a first control signal;
      an amplifier comprising a first input and an output, the amplifier being configured to generate an output signal by amplifying the input signal; and
      an output terminal coupled to the output of the amplifier, the output terminal being configured to provide the output signal.
11. The apparatus of embodiment 10, further comprising a second switch coupled to the input terminal and the first input of the amplifier.
12. The apparatus of embodiment 10, wherein the first transistor is coupled to the input terminal and a first node, the level-shifter is configured to provide a first voltage at the first node, and the first voltage is greater than a second voltage at the input terminal by a first offset.
13. The apparatus of embodiment 12, wherein the first circuit is configured to conduct a transient current between the input terminal and the first node in response to a voltage transient event.
14. The apparatus of embodiment 10, wherein the first switch comprises a third transistor comprising a bulk terminal coupled to the first supply voltage.
15. The apparatus of embodiment 10, wherein the second transistor comprises an emitter terminal coupled to the input terminal.
16. The apparatus of embodiment 10, wherein the second circuit is configured to limit a direct current (DC) voltage level applied to the input terminal in response to a voltage stress condition.
17. An apparatus comprising:
   an input terminal configured to receive an input signal;
   a first circuit coupled to the input terminal, the first circuit comprising a first transistor coupled to the input terminal and a first node, the first circuit is configured to conduct a transient current between the input terminal and the first node in response to a voltage transient event;
   a second circuit coupled to the first circuit, the second circuit comprising a second transistor, the second transistor comprising a base terminal coupled to a first supply voltage;
   a first switch coupled to the input terminal and a ground potential, the first switch being configured to establish a first conduction path between the input terminal and the ground potential in response to a first control signal;
   an amplifier comprising a first input and an output, the amplifier being configured to generate an output signal by amplifying the input signal;
   a second switch coupled to the input terminal and the first input of the amplifier; and
   an output terminal coupled to the output of the amplifier, the output terminal being configured to provide the output signal.
18. The apparatus of embodiment 17, wherein the first circuit further comprises a level-shifter coupled to the first transistor and configured to provide a first bias voltage to the first transistor.
19. The apparatus of embodiment 18, wherein the first transistor is coupled to the input terminal and the first node, the level-shifter is configured to provide a first voltage at the first node, the first voltage is greater than a second voltage at the input terminal by a first offset.
20. The apparatus of embodiment 16, wherein the first switch comprises a third transistor comprising a bulk terminal coupled to the first supply voltage.

## Claims

1. An apparatus comprising:
an input terminal configured to receive an input signal;
a first circuit coupled to the input terminal, the first circuit comprising:
a first transistor coupled to the input terminal; and
a level-shifter coupled to the first transistor and configured to provide a first bias voltage to the first transistor;
a second circuit coupled to the first circuit, the second circuit comprising a second transistor, the second transistor comprising a base terminal coupled to a first supply voltage;
a first switch coupled to the input terminal and a ground potential, the first switch being configured to establish a first conduction path between the input terminal and the ground potential in response to a first control signal;
an amplifier comprising a first input and an output, the amplifier being configured to generate an output signal by amplifying the input signal;
a second switch coupled to the input terminal and the first input of the amplifier; and
an output terminal coupled to the output of the amplifier, the output terminal being configured to provide the output signal.

2. The apparatus of claim 1, wherein the first transistor is coupled to the input terminal and a first node, the level-shifter is configured to provide a first voltage at the first node, the first voltage is greater than a second voltage at the input terminal by a first offset.

3. The apparatus of claim 2, wherein the level-shifter comprises a voltage generator coupled to the first node, the voltage generator is configured to determine the first offset, and/or
wherein the first circuit is configured to conduct a transient current between the input terminal and the first node in response to a voltage transient event.

4. The apparatus according to at least one of the preceding claims, wherein:
the amplifier further comprises a second input; and
the apparatus further comprises a third switch coupled to the first input and the second input of the amplifier, the third switch is configured to establish a second conduction path between the first input and the second input of the amplifier in response to a second control signal.

5. The apparatus according to claim 4, further comprising a fourth switch coupled to the first input and the output of the amplifier.

6. The apparatus according to at least one of the preceding claims, wherein the second transistor comprises an emitter terminal coupled to the input terminal, and/or
wherein the second circuit is configured to limit a direct current (DC) voltage level applied to the input terminal in response to a voltage stress condition, and/or
wherein the first switch comprises a third transistor comprising a bulk terminal coupled to the first supply voltage.

7. An apparatus comprising:
an input terminal configured to receive an input signal;
a first circuit coupled to the input terminal, the first circuit comprising:
a first transistor coupled to the input terminal; and
a level-shifter coupled to the first transistor and configured to provide a first bias voltage to the first transistor;
a second circuit coupled to the first circuit, the second circuit comprising a second transistor, the second transistor comprising a base terminal coupled to a first supply voltage;
a first switch coupled to the input terminal and a ground potential, the first switch being configured to establish a first conduction path between the input terminal and the ground potential in response to a first control signal;
an amplifier comprising a first input and an output, the amplifier being configured to generate an output signal by amplifying the input signal; and
an output terminal coupled to the output of the amplifier, the output terminal being configured to provide the output signal.

8. The apparatus according to claim 7, further comprising a second switch coupled to the input terminal and the first input of the amplifier.

9. The apparatus according to at least one of claims 7 or 8, wherein the first transistor is coupled to the input terminal and a first node, the level-shifter is configured to provide a first voltage at the first node, and the first voltage is greater than a second voltage at the input terminal by a first offset.

10. The apparatus according to claim 9, wherein the first circuit is configured to conduct a transient current between the input terminal and the first node in response to a voltage transient event.

11. The apparatus according to at least one of claims 7 to 10, wherein the first switch comprises a third transistor comprising a bulk terminal coupled to the first supply voltage, and/or
wherein the second transistor comprises an emitter terminal coupled to the input terminal, and/or
wherein the second circuit is configured to limit a direct current (DC) voltage level applied to the input terminal in response to a voltage stress condition.

12. An apparatus comprising:
an input terminal configured to receive an input signal;
a first circuit coupled to the input terminal, the first circuit comprising a first transistor coupled to the input terminal and a first node, the first circuit is configured to conduct a transient current between the input terminal and the first node in response to a voltage transient event;
a second circuit coupled to the first circuit, the second circuit comprising a second transistor, the second transistor comprising a base terminal coupled to a first supply voltage;
a first switch coupled to the input terminal and a ground potential, the first switch being configured to establish a first conduction path between the input terminal and the ground potential in response to a first control signal;
an amplifier comprising a first input and an output, the amplifier being configured to generate an output signal by amplifying the input signal;
a second switch coupled to the input terminal and the first input of the amplifier; and
an output terminal coupled to the output of the amplifier, the output terminal being configured to provide the output signal.

13. The apparatus according to claim 12, wherein the first circuit further comprises a level-shifter coupled to the first transistor and configured to provide a first bias voltage to the first transistor.

14. The apparatus according to claim 13, wherein the first transistor is coupled to the input terminal and the first node, the level-shifter is configured to provide a first voltage at the first node, the first voltage is greater than a second voltage at the input terminal by a first offset.

15. The apparatus according to claim 12, wherein the first switch comprises a third transistor comprising a bulk terminal coupled to the first supply voltage.
